# EUROPEAN PATENT APPLICATION

(11) **EP 4 421 887 A1**
(43) Date of publication of application: **28.08.2024**
(21) Application number: 22883464.4
(22) Date of filing: 13.10.2022
(51) Int. Cl.: H01L 33/02, H01L 21/02, H01L 21/20

(54) **METHOD FOR MANUFACTURING JUNCTION SEMICONDUCTOR WAFER**

(30) Priority: 18.10.2021 JP 2021170297
(71) Applicant: Shin-Etsu Handotai Co., Ltd., Tokyo 100-0004 (JP)
(72) Inventor: ISHIZAKI, Junya, Annaka-shi, Gunma 379-0196 (JP)
(74) Representative: Mooser, Sebastian Thomas
(86) International application number: PCT/JP2022/038227
(87) International publication number: WO 2023/068160

(57) **Abstract**

The present invention provides a method for manufacturing a bonded semiconductor wafer, the method includes the steps of epitaxially growing an etching stop layer on a starting substrate, epitaxially growing a compound semiconductor functional layer on the etching stop layer, forming an isolation groove for forming a device in the compound semiconductor functional layer by a dry etching method, etching on a surface of the isolation groove by a wet etching method, bonding a visible light-transmissive substrate of a different material from a material of the compound semiconductor functional layer to the compound semiconductor functional layer via a visible light-transmissive thermosetting bonding member, and obtaining a bonded semiconductor wafer by removing the starting substrate from the compound semiconductor functional layer bonded to the visible light-transmissive substrate. This can provide a method for manufacturing a bonded semiconductor wafer that can make a device with suppressed generation of decrease in brightness when the device is produced on a substrate.

## Description

### TECHNICAL FIELD

The present invention relates to a method for manufacturing a bonded semiconductor wafer, particularly a method for manufacturing a bonded semiconductor wafer for a micro-LED.

### BACKGROUND ART

A technique to separate only compound semiconductor functional layers (epitaxial functional layers) from starting substrates and transfer thereof to another substrate is an important technique to mitigate restriction due to physical properties of the starting substrates and to increase the degree of freedom in designing device systems.

Concerning micro-LED devices, transferring the devices staying on the starting substrates to a drive circuit is difficult, and a transferring technique is indispensable. To produce a donor substrate capable of performing the transferring to the drive circuit suitable for the micro LED device, a technique is necessary in which a compound semiconductor functional layer is bonded to a visible light-transmissive substrate as a permanent substrate, and then the starting substrate is removed, and thus the transfer is realized.

Moreover, in the micro-LED device, at the same time as the problem of the donor substrate production, the problem is that reducing the micro-LED size generates a brightness decrease.

Patent Document 1 discloses a technique to bond a semiconductor epitaxial substrate to a temporary supporting substrate via a dielectric layer by thermocompression and a technique to separate the temporary supporting substrate from an epitaxial functional layer by wet etching.

In Patent Document 1, an oxide layer is formed on a surface of an epitaxial wafer and then a temporary support treatment is performed, followed by delamination of a starting substrate by sacrificial-layer etching. A miniaturized micro-LED can be realized by using the technique in Patent Document 1; however, no improvement measure toward the brightness decrease has been shown.

Patent Document 2 discloses a technique in which after an isolation groove for exposing a sacrificial layer is formed, bonding is performed, and then sacrificial-layer etching is performed, thereby separating a starting substrate.

In this way, in Patent Document 2, the isolation groove is formed, and the sacrificial-layer etching is performed via the isolation groove. A miniaturized micro-LED can be realized using the technique in Patent Document 2; however, no improvement measure toward the brightness decrease was presented.

### CITATION LIST

### PATENT LITERATURE

Patent Document 1: JP 2021-27301 A
Patent Document 2: WO 2014/020906 A1

### SUMMARY OF INVENTION

### TECHNICAL PROBLEM

A transfer preparation wafer mounting LED dice for mounting a micro-LED display is an indispensable structure to realize the micro-LED display. In order to realize laser lift-off by irradiation with an excimer laser, it is necessary to bond the LED dice to a visible light-transmissive substrate, such as a sapphire substrate, with a bonding member absorbing the laser. It is preferred that the bonding member is transparent to visible light and can be coated by a simple and easy method, such as spin-coating, and in particular, is a material which is in a liquid state during coating and to be cured by a treatment such as heat, light, or time course.

Conventionally, an LED device is formed by forming a uniform bonding film on the visible light-transmissive substrate, bonding an epitaxial wafer, and then removing a starting substrate, as in Patent Documents 1 and 2. In this case, a dry-etching treatment is performed in a device-forming step, and an ICP step is usually applied. At the time, damage is inflicted on the side surfaces subjected to an etching treatment. This damage is not noticeable as remarkable current leakage, but it causes a brightness decrease when light emitting due to electro luminescence. This tendency is significant for a smallsize LED, such as a micro-LED, and becomes a problem.

As things described above, a solution to the problem of brightness decrease (brightness droop) as the size of the micro-LED decreases is needed.

The present invention has been made in view of the above-described problem. An object of the present invention is to provide a method for manufacturing a bonded semiconductor wafer that can be made into a device with suppressed generation of brightness decrease when the device is produced on a substrate.

### SOLUTION TO PROBLEM

To achieve the object, the present invention provides a method for manufacturing a bonded semiconductor wafer, the method comprising the steps of:
epitaxially growing an etching stop layer on a starting substrate;
epitaxially growing a compound semiconductor functional layer on the etching stop layer;
forming an isolation groove for forming a device in the compound semiconductor functional layer by a dry etching method;
etching on a surface of the isolation groove by a wet etching method;
bonding a visible light-transmissive substrate of a different material from a material of the compound semiconductor functional layer to the compound semiconductor functional layer via a visible light-transmissive thermosetting bonding member; and
obtaining a bonded semiconductor wafer by removing the starting substrate from the compound semiconductor functional layer bonded to the visible light-transmissive substrate.

By virtue of such a method for manufacturing the bonded semiconductor wafer, a damaged layer on a surface of the isolation groove formed by the dry etching is removed by the wet etching, thus the brightness decrease of a small size light emitting device, such as a micro-LED, can be suppressed.

The step of bonding, the step of obtaining the bonded semiconductor wafer by removing the starting substrate, the step of forming the isolation groove, and the step of etching by the wet etching method can be performed in this first order, or
the step of forming the isolation groove, the step of etching by the wet etching method, the step of bonding, and the step of obtaining the bonded semiconductor wafer by removing the starting substrate can be performed in this second order.

In the inventive method for manufacturing the bonded semiconductor wafer, each step may be performed in the first order described above or may be performed in the second order described above.

It is possible that in the step of forming the isolation groove, the isolation groove be formed in the compound semiconductor functional layer, and thus, one side of the device be 100 um or less.

In the inventive method for manufacturing the bonded semiconductor wafer, the effect becomes particularly remarkable in the case where one side of the device to be formed is to be 100 um or less.

The device can be a micro-LED structure having a light emitting layer and a window layer.

The present invention is particularly effective for the micro-LED structure, in which the device has the light emitting layer and the window layer.

In addition, an etching removal of the wet etching is preferably 50 nm or more.

By making the etching removal of the wet etching to 50 nm or more, the damage on the surface of the isolation groove can be reliably removed; thus, degradation of luminous efficacy can be reliably suppressed.

The visible light-transmissive substrate can be selected from the group consisting of, for example, sapphire, quartz, glass, SiC, LiTaO₃, and LiNbO₃.

Moreover, the visible light-transmissive thermosetting bonding material can be selected from the group consisting of, for example, BCB, silicone resin, epoxy resin, SOG, polyimide, and amorphous fluoropolymer.

These materials can be used as the materials for the visible light-transmissive substrate and the visible light-transmissive thermosetting bonding material, but the materials are not limited thereto.

A thickness of the visible light-transmissive thermosetting bonding member is preferably 0.01 um or more and 0.6 um or less.

By making the thickness of the visible light-transmissive thermosetting bonding member 0.01 um or more and 0.6 um or less, a thickness distribution of the bonding member can be relatively small, and hence preferred.

The visible light-transmissive thermosetting bonding member may not be thermally cured.

When the visible light-transmissive thermosetting bonding member is made not to be thermally cured, the visible light-transmissive substrate can be easily delaminated in the case of a need for delaminating thereof.

### ADVANTAGEOUS EFFECTS OF INVENTION

As described above, the inventive method for manufacturing the bonded semiconductor wafer can make the device in which generation of decreased brightness is suppressed when the device, particularly the micro-LED, is produced on the substrate.

### BRIEF DESCRIPTION OF DRAWINGS

FIG. 1 is a schematic cross-sectional view illustrating a part of the first embodiment of a method for manufacturing a bonded semiconductor wafer according to the present invention.
FIG. 2 is a schematic cross-sectional view illustrating another part of the first embodiment of a method for manufacturing a bonded semiconductor wafer according to the present invention.
FIG. 3 is a schematic cross-sectional view illustrating another part of the first embodiment of a method for manufacturing a bonded semiconductor wafer according to the present invention.
FIG. 4 is a schematic cross-sectional view illustrating another part of the first embodiment of a method for manufacturing a bonded semiconductor wafer according to the present invention.
FIG. 5 is a schematic cross-sectional view illustrating another part of the first embodiment of a method for manufacturing a bonded semiconductor wafer according to the present invention.
FIG. 6 is a schematic cross-sectional view illustrating another part of the first embodiment of a method for manufacturing a bonded semiconductor wafer according to the present invention.
FIG. 7 is a schematic cross-sectional view illustrating another part of the first embodiment of a method for manufacturing a bonded semiconductor wafer according to the present invention.
FIG. 8 is a schematic cross-sectional view illustrating another part of the first embodiment of a method for manufacturing a bonded semiconductor wafer according to the present invention.
FIG. 9 is a schematic cross-sectional view illustrating another part of the first embodiment of a method for manufacturing a bonded semiconductor wafer according to the present invention.
FIG. 10 is a schematic cross-sectional view of an example of a bonded semiconductor wafer obtainable in the first embodiment of a method for manufacturing the bonded semiconductor wafer according to the present invention.
FIG. 11 is a schematic cross-sectional view illustrating a part of the second embodiment of a method for manufacturing a bonded semiconductor wafer according to the present invention.
FIG. 12 is a schematic cross-sectional view illustrating another part of the second embodiment of a method for manufacturing a bonded semiconductor wafer according to the present invention.
FIG. 13 is a schematic cross-sectional view illustrating another part of the second embodiment of a method for manufacturing a bonded semiconductor wafer according to the present invention.
FIG. 14 is a schematic cross-sectional view illustrating another part of the second embodiment of a method for manufacturing a bonded semiconductor wafer according to the present invention.
FIG. 15 is a schematic cross-sectional view illustrating another part of the second embodiment of a method for manufacturing a bonded semiconductor wafer according to the present invention.
FIG. 16 is a schematic cross-sectional view illustrating another part of the second embodiment of a method for manufacturing a bonded semiconductor wafer according to the present invention.
FIG. 17 is a schematic cross-sectional view illustrating another part of the second embodiment of a method for manufacturing a bonded semiconductor wafer according to the present invention.
FIG. 18 is a schematic cross-sectional view illustrating another part of the second embodiment of a method for manufacturing a bonded semiconductor wafer according to the present invention.
FIG. 19 is a schematic cross-sectional view illustrating another part of the second embodiment of a method for manufacturing a bonded semiconductor wafer according to the present invention.
FIG. 20 is a schematic cross-sectional view of an example of a bonded semiconductor wafer obtainable in the second embodiment of a method for manufacturing the bonded semiconductor wafer according to the present invention.
FIG. 21 is a schematic cross-sectional view illustrating a part of the third embodiment of a method for manufacturing a bonded semiconductor wafer according to the present invention.
FIG. 22 is a schematic cross-sectional view illustrating another part of the third embodiment of a method for manufacturing a bonded semiconductor wafer according to the present invention.
FIG. 23 is a schematic cross-sectional view illustrating another part of the third embodiment of a method for manufacturing a bonded semiconductor wafer according to the present invention.
FIG. 24 is a schematic cross-sectional view illustrating another part of the third embodiment of a method for manufacturing a bonded semiconductor wafer according to the present invention.
FIG. 25 is a schematic cross-sectional view illustrating another part of the third embodiment of a method for manufacturing a bonded semiconductor wafer according to the present invention.
FIG. 26 is a schematic cross-sectional view illustrating another part of the third embodiment of a method for manufacturing a bonded semiconductor wafer according to the present invention.
FIG. 27 is a schematic cross-sectional view illustrating another part of the third embodiment of a method for manufacturing a bonded semiconductor wafer according to the present invention.
FIG. 28 is a schematic cross-sectional view illustrating another part of the third embodiment of a method for manufacturing a bonded semiconductor wafer according to the present invention.
FIG. 29 is a schematic cross-sectional view illustrating another part of the third embodiment of a method for manufacturing a bonded semiconductor wafer according to the present invention.
FIG. 30 is a schematic cross-sectional view illustrating another part of the third embodiment of a method for manufacturing a bonded semiconductor wafer according to the present invention.
FIG. 31 is a schematic cross-sectional view illustrating another part of the third embodiment of a method for manufacturing a bonded semiconductor wafer according to the present invention.
FIG. 32 is a schematic cross-sectional view of an example of a bonded semiconductor wafer obtainable in the third embodiment of a method for manufacturing the bonded semiconductor wafer according to the present invention.
FIG. 33 is a schematic cross-sectional view illustrating a part of a method for manufacturing a bonded semiconductor wafer of Comparative Example.
FIG. 34 is a schematic cross-sectional view illustrating another part of a method for manufacturing a bonded semiconductor wafer of Comparative Example.
FIG. 35 is a schematic cross-sectional view illustrating another part of a method for manufacturing a bonded semiconductor wafer of Comparative Example.
FIG. 36 is a schematic cross-sectional view illustrating another part of a method for manufacturing a bonded semiconductor wafer of Comparative Example.
FIG. 37 is a schematic cross-sectional view illustrating another part of a method for manufacturing a bonded semiconductor wafer of Comparative Example.
FIG. 38 is a schematic cross-sectional view illustrating another part of a method for manufacturing a bonded semiconductor wafer of Comparative Example.
FIG. 39 is a schematic cross-sectional view illustrating another part of a method for manufacturing a bonded semiconductor wafer of Comparative Example.
FIG. 40 is a schematic cross-sectional view of a bonded semiconductor wafer obtained by a method for manufacturing the bonded semiconductor wafer of Comparative Example.
FIG. 41 is a graph illustrating a relation between a device design size and luminous efficacy regarding Examples 1 to 3 and Comparative Example.
FIG. 42 is a graph illustrating a relation between an etching removal and luminous efficacy in Example 2.

### DESCRIPTION OF EMBODIMENTS

As described above, the development of a method for manufacturing a bonded semiconductor wafer, which can be a device with suppressed generation of brightness decrease when the device is produced on a substrate, is required.

The present inventors have earnestly studied the problem described above and found that brightness decrease of the device can be suppressed by removing a damaged layer, which was formed on a surface of an isolation groove due to dry etching, by virtue of a wet etching, and completed the present invention.

That is, the present invention is a method for manufacturing a bonded semiconductor wafer, the method comprising the steps of:
epitaxially growing an etching stop layer on a starting substrate;
epitaxially growing a compound semiconductor functional layer on the etching stop layer;
forming an isolation groove for forming a device in the compound semiconductor functional layer by a dry etching method;
etching on a surface of the isolation groove by a wet etching method;
bonding a visible light-transmissive substrate of a different material from a material of the compound semiconductor functional layer to the compound semiconductor functional layer via a visible light-transmissive thermosetting bonding member; and
obtaining a bonded semiconductor wafer by removing the starting substrate from the compound semiconductor functional layer bonded to the visible light-transmissive substrate.

Hereinafter, the present invention will be described in detail with reference to the drawings. However, the present invention is not limited thereto.

### (First Embodiment)

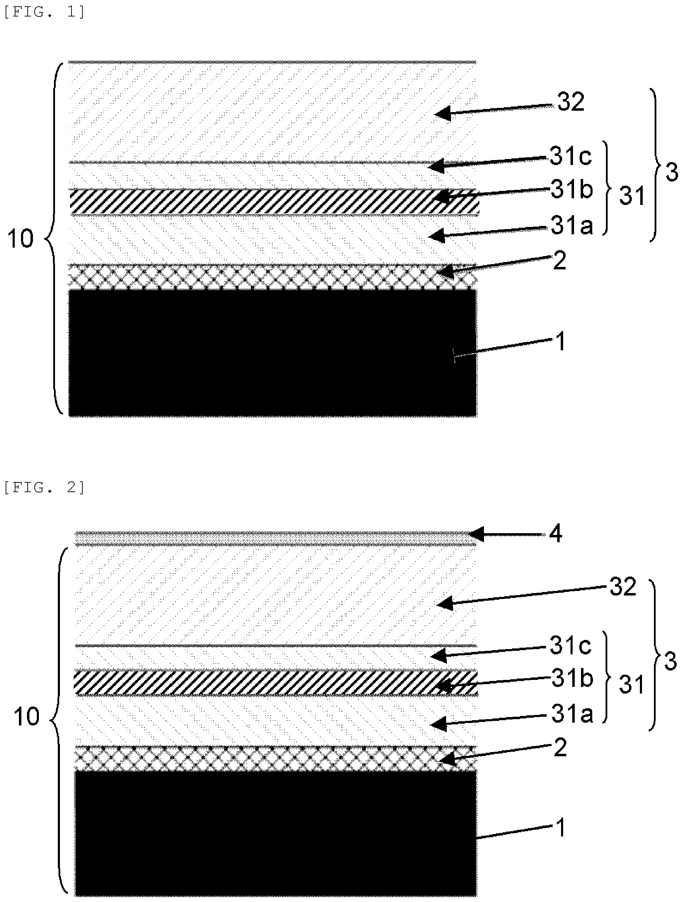

Hereinafter, referring to FIG. 1 to FIG. 10, the first embodiment of the inventive method for manufacturing the bonded semiconductor wafer is described.

To begin with, as shown in FIG. 1, an etching stop layer 2 is epitaxially grown on a first conductivity-type GaAs starting substrate 1 after laminating a first conductivity-type GaAs buffer layer (not shown) thereon. The etching stop layer 2 shown in FIG. 1 includes a first conductivity-type GaInP first etching stop layer and a first conductivity-type GaAs second etching stop layer (not shown, respectively).

Then, as shown in FIG. 1, on the etching stop layer 2, a first conductivity-type first cladding layer 31a of AlGaInP, a non-doped AlGaInP active layer 31b, a second conductivity-type second cladding layer 31c of AlGaInP, a second conductivity-type intermediate layer of GaInP, a second conductivity type GaP window layer 32 are epitaxially grown in sequence. Besides, the GaInP intermediate layer is not shown. Consequently, an epitaxial wafer 10 having a light emitting device structure as a compound semiconductor functional layer (epitaxial functional layer) 3 epitaxially grown on the etching stop layer 2 is provided. At this point, from the first cladding layer 31a to the second cladding layer 31c is referred to as a double-hetero (DH) structure part 31.

Then, as shown in FIG. 2, such as benzocyclobutene (BCB) is spin-coated as a visible light-transmissive thermosetting bonding material on the compound semiconductor functional layer 3 of the epitaxial wafer 10 to obtain a visible light-transmissive thermosetting bonding material coating film (BCB coating film) 4.

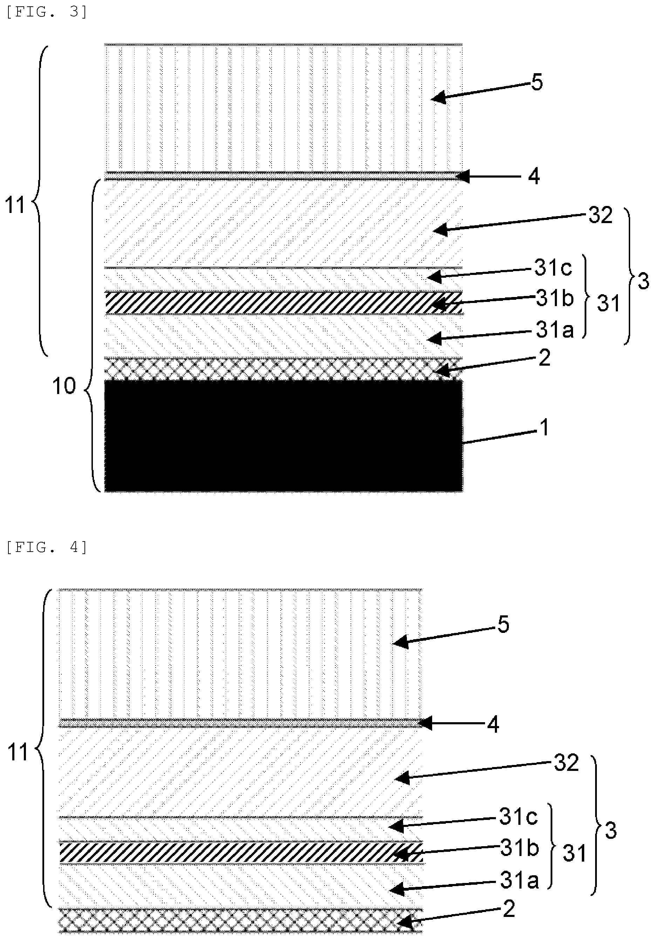

And then, as shown in FIG. 3, a visible light-transmissive substrate 5 as a to-be-bonded wafer, such as a sapphire wafer, is superimposed on the compound semiconductor functional layer 3 while facing this via the BCB coating film 4 sandwiched therebetween, and thermocompression-bonding is performed, thereby producing a bonded semiconductor wafer (epitaxial wafer bonded substrate) 11 in which the compound semiconductor functional layer 3 of the epitaxial wafer 10 and the sapphire wafer 5 are bonded to each other via the BCB coating film 4.

When the BCB coating film 4 is coated by spin-coating, a thickness thereof can be about 0.01 um or more and 0.6 um or less. The thickness in this range is preferred because a thickness distribution of the coating film 4 of BCB as a bonding member can be relatively small.

However, a BCB layer thickness of 0.05 um or more is suitable to maintain an area yield of 90 % or more after bonding. If the area yield of 70 % or more after bonding only needs to be maintained, the BCB layer thickness may be 0.01 um or more.

In this embodiment, the visible light-transmissive substrate 5 is exemplified as sapphire; however, the visible light-transmissive substrate 5 is not limited to sapphire. Any material can be selected as long as it is a different material from the compound semiconductor functional layer 3, flatness is secured, and absorptivity for excimer laser light is low. In addition to sapphire, for example, quartz such as synthetic quartz, glass, SiC, LiTaO₃, or LiNbO₃ can be selected.

In addition, the visible light-transmissive thermosetting bonding material is exemplified as BCB; however, the visible light-transmissive thermosetting bonding material is not limited to BCB. Any material can be selected as long as it has visible lighttransmissivity and thermosetting properties. In addition to BCB, for example, silicone resin, epoxy resin, SOG (spin-on-glass), PI (polyimide), and amorphous fluororesin (such as CYTOP (registered trademark)) may be used.

Then, as shown in FIG. 4, the GaAs starting substrate 1 is removed by the wet etching with selective etchant such as ammonia-hydrogen peroxide mixture. By this means, the GaAs starting substrate 1 is removed from the compound semiconductor functional layer 3 bonded to the visible light-transmissive substrate 5.

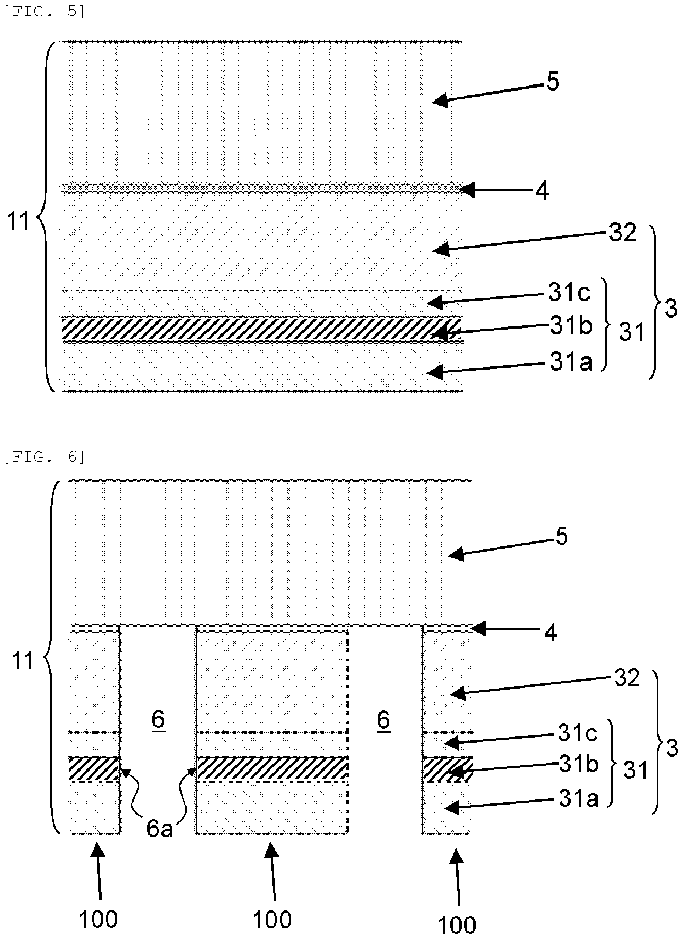

After the first etching stop layer of the etching stop layer 2 is exposed, the etchant is switched to a hydrochloric acid-based etchant to remove the first etching stop layer of GaInP selectively, and then the etchant is switched to a peroxide sulfuric-based etchant and the second etching stop layer is removed. Thereby, the etching stop layer 2 is removed, and the first cladding layer 31a is exposed, as shown in FIG. 5.

Then, a resist mask or a hard mask is formed on the compound semiconductor functional layer 3 by a photolithography method, and from the first cladding layer 31a to the GaP window layer 32 are etched by the dry etching method using chlorine-based plasma to form an isolation groove 6. Thus, devices (device separation edges) 100 in an island-shaped pattern separated from each other by the isolation groove 6 in the compound semiconductor functional layer 3, as shown in FIG. 6. When the devices 100 are devices for micro-LED, one side of each of the devices 100 is preferably 100 um or less. The preferred lower limit of length of one side of the device is not particularly limited but is, for example, 1 um or more.

FIG. 6 shows a state in which a BCB coating film 4, being a bonding layer, is also etched when the isolation groove 6 is formed; however, a step is not limited to the step to remove the BCB coating film 4, and the BCB coating film 4 may remain on the bottom of the isolation groove 6. When removing the BCB coating film 4, switching from the material gas used for etching the compound semiconductor functional layer 3 to a fluorine-based gas is performed, and the etching treatment is performed.

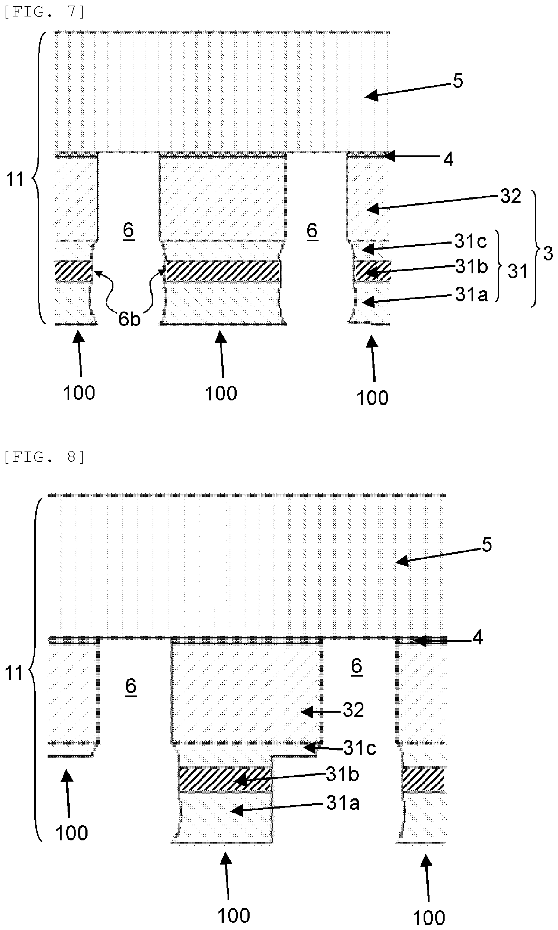

Subsequently, after performing the isolation groove formation step by the dry etching method, the wet etching treatment is performed on a surface 6a of the isolation groove 6 shown in FIG. 6 by, for example, sulfuric acid-hydrogen peroxide mixture (SPM) solution (step to etching on the surface 6a of the isolation groove 6 by the wet etching method). Consequently, as shown in FIG. 7, the surface 6a of the isolation groove 6 (a part of a side surface of the compound semiconductor functional layer 3) becomes a wet etched surface 6b. By virtue of thus-performing the wet etching, a damaged layer formed by the dry etching on the surface 6a of the isolation groove 6, i.e., the side surface of the compound semiconductor functional layer 3 can be removed, thereby suppressing the brightness decrease of the device 100 such as the micro-LED.

In the wet etching treatment, an etching removal is preferably 50 nm or more so as to sufficiently remove damage at the active layer 31b portion of the device 100 (device separation edge). By virtue of thus-performing wet etching of 50 nm or more, the damaged layer on the surface 6a of the isolation groove 6 can be more reliably removed, and thereby the brightness decrease of the device 100, such as the micro-LED, can be further suppressed. The preferred upper limit of the etching removal by the wet etching treatment is not particularly limited, but the etching removal can be, for example, 1 um or less.

When the sulfuric acid-hydrogen peroxide mixture solution is used in the wet etching method, as a mixing ratio of each component in the sulfuric acid-hydrogen peroxide mixture solution, for example, a sulfuric acid : hydrogen peroxide : water in the ratio of 1 : 1 : 20 can be adopted, but not limited to this ratio. Since the speed of damage etching varies depending on the ratio of sulfuric acid and hydrogen peroxide, the same effect can be obtained in the condition of, for example, a sulfuric acid : hydrogen peroxide : water ratio of 20 : 1 : 1 where sulfuric acid is in excess or, vice versa, in the condition where hydrogen peroxide is in excess. An etchant other than the sulfuric acid-hydrogen peroxide mixture solution can be used in the wet etching method.

Then, a resist pattern or a hard mask pattern is formed on the surface of the device 100 by the photolithography method, and then the device 100 is etched by, for example, the dry etching method using chlorine-based plasma to expose a part of the second cladding layer 31c as shown in FIG. 8.

FIG. 8 shows a state in which the second cladding layer 31c is etched to the middle portion of the layer; however, an etched depth is not limited to this depth, and the same effect can be obtained at any depth as long as the etching passes through the active layer 31b. The same effects can be obtained, for example, in the state where a part of the active layer 31b is completely eliminated in the depth direction and the second cladding layer 31c is almost unetched, or in the state where a part of the second cladding layer 31c is completely etched in the depth direction and the GaP window layer 32 is exposed.

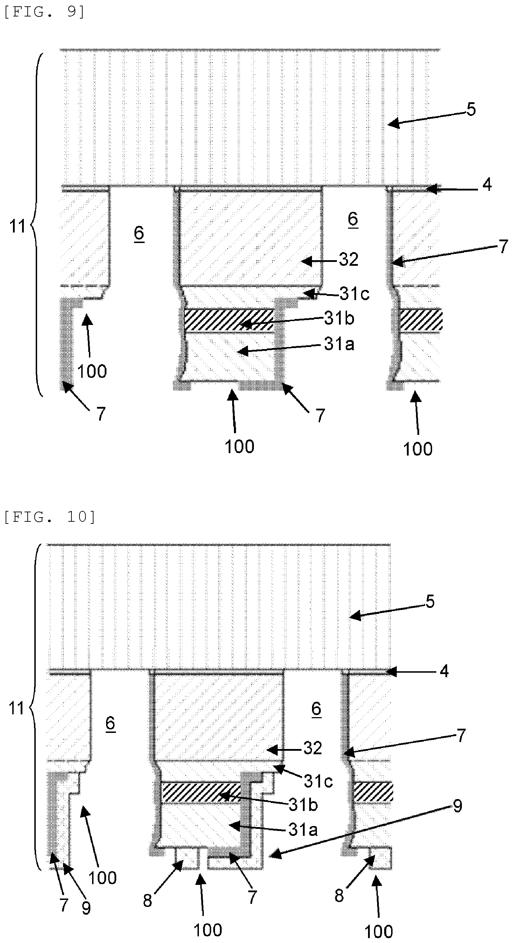

Then, a passivation (PSV) film 7, such as SiO₂, is formed on the surface of the device 100, and then PSV pattern film 7 is produced, the pattern film being processed so that, as shown in FIG. 9, a side surface of the exposed active layer 31b in the device (device separation edge portion) 100 is coated and a part of the first cladding layer 31a and a part of the second cladding layer 31c are exposed.

It should be noted that the PSV film 7 is not limited to SiO₂ film, but any material can be selected as long as a material has an insulating property.

Moreover, the PSV film 7 can be formed by a P-CVD (plasma CVD) method using TEOS and O₂, for example. However, the formation method of the PSV film 7 is not limited to this method, but the same effect can be obtained when formed by methods such as a sputtering method, a PLD method, an ALD method, and a sol-gel method as long as the PSV film 7 can be formed.

Then, as shown in FIG. 10, electrodes 8 and 9 are formed on the part of the first cladding layer 31a and the part of the second cladding layer 31c exposed from the opening of the PSV pattern film 7, respectively, and heat treatment is performed to realize an ohmic contact.

At this point, Au-based materials can be adopted for materials of the electrodes 8 and 9. In addition, when the electrode is provided near a P-type layer, an Au metallic layer containing Be or Zn is preferably provided in the vicinity (within 0.5 um) of the compound semiconductor functional layer 3. When the electrode is provided near an N-type layer, an Au metallic layer containing Ge or Si is preferably provided in the vicinity (within 0.5 um) of the compound semiconductor functional layer 3.

Moreover, in FIG. 10, a design is exemplified in which a lead layer is provided with the electrode 9 in contact with the second cladding layer 31c and up to the height of the first cladding layer 31a; however, the design is not limited to the design having a lead structure. Without providing the lead structure, a structure may also be used in which the thickness of electrode 9 in contact with the second cladding layer 31c is designed to be thicker than that of electrode 8 on the first cladding layer 31a to reduce a difference in levels.

According to the first embodiment of the inventive method for manufacturing the bonded semiconductor wafer, described above, it is possible to manufacture a bonded semiconductor wafer 11, including a plurality of the devices 100 bonded to the visible light-transmissive substrate 5 via a visible light-transmissive thermosetting bonding member coating film 4, as shown in FIG. 10. In FIG. 10, a plurality of the devices 100 are light emitting devices, and more specifically, micro-LED structures each having an active layer 31b, which is a light emitting layer, and a window layer 32.

In this embodiment, as described with referring to FIG. 7, after the isolation groove formation step by the dry etching method, the wet etching is performed on the surface 6a of the isolation groove 6, specifically, a surface (the side surface) of the compound semiconductor functional layer 3 by the wet etching method, thereby removing the damaged layer on the surface of the compound semiconductor functional layer 3 formed by the dry etching. Therefore, the brightness decrease of the device 100, being the micro-LED, can be suppressed.

### (Second Embodiment)

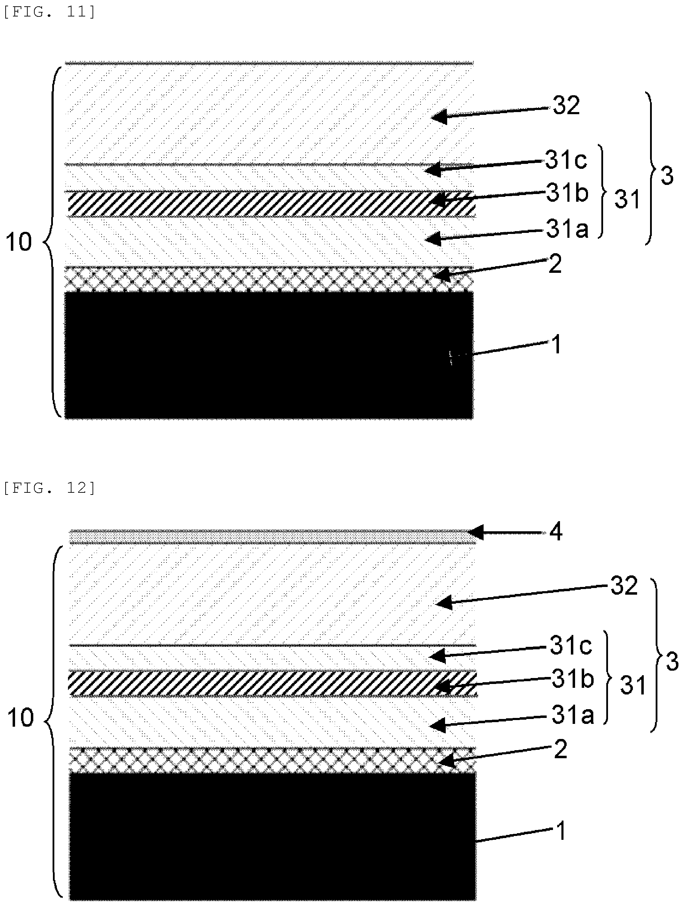

Next, referring to FIG. 11 to FIG. 20, the second embodiment of the inventive method for manufacturing the bonded semiconductor wafer is described.

The second embodiment generally differs from the first embodiment mainly in that after forming an isolation groove 6, dry etching is performed on a device 100, and then wet etching is performed on a surface 6a of the isolation groove 6.

To begin with, as shown in FIG. 11, according to the same procedure described in the first embodiment, an etching stop layer 2 is epitaxially grown on a first conductivity-type starting substrate 1 of GaAs the, then a compound semiconductor functional layer 3 is epitaxially grown on an etching stop layer 2. Thus, an epitaxial wafer 10 having a light emitting device structure as the compound semiconductor functional layer (epitaxial functional layer) 3 epitaxially grown on the etching stop layer 2 is provided, as shown in FIG. 11.

Then, as shown in FIG. 12, benzocyclobutene (BCB) as the visible light-transmissive thermosetting bonding member is spin-coated on the compound semiconductor functional layer 3 of the epitaxial wafer 10 to obtain a visible light-transmissive thermosetting bonding material coating film (BCB coating film) 4.

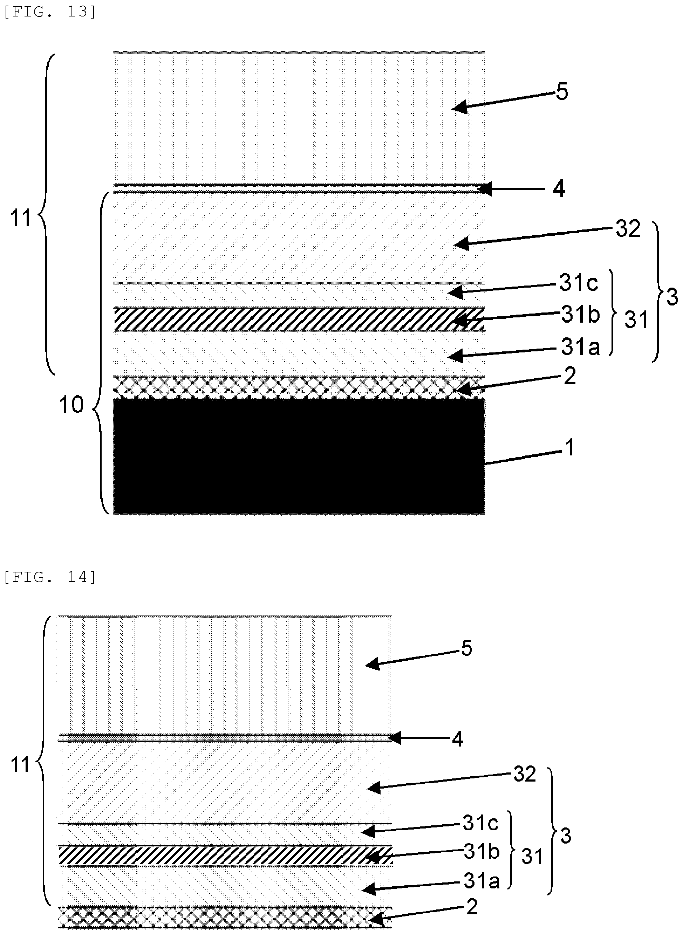

And then, as shown in FIG. 13, a visible light-transmissive substrate 5 as a to-be-bonded wafer, such as a sapphire wafer, is superimposed on the compound semiconductor functional layer 3 while facing this via the BCB coating film 4 sandwiched therebetween, and thermocompression-bonding is performed, thereby producing a bonded semiconductor wafer (epitaxial wafer bonded substrate) 11 in which the compound semiconductor functional layer 3 of the epitaxial wafer 10 and the sapphire wafer 5 are bonded to each other via the BCB coating film 4.

When BCB is coated by spin-coating, a thickness thereof can be about 0.01 um or more and 0.6 um or less, as in the first embodiment.

However, a BCB layer thickness of 0.05 um or more is suitable to maintain an area yield of 90 % or more after bonding. If the area yield of 70 % or more after bonding only needs to be maintained, the BCB layer thickness may be 0.01 um or more.

In this embodiment, the visible light-transmissive substrate 5 is exemplified as sapphire, and the visible light-transmissive thermosetting bonding material is exemplified as BCB; however, the examples are not limited to thereto. Other usable examples are the same as the examples mentioned in the first embodiment.

Then, as shown in FIG. 14, the GaAs starting substrate 1 is removed by the wet etching with a selective etchant such as ammonia-hydrogen peroxide mixture. By this means, the GaAs starting substrate 1 is removed from the compound semiconductor functional layer 3 bonded to the visible light-transmissive substrate 5.

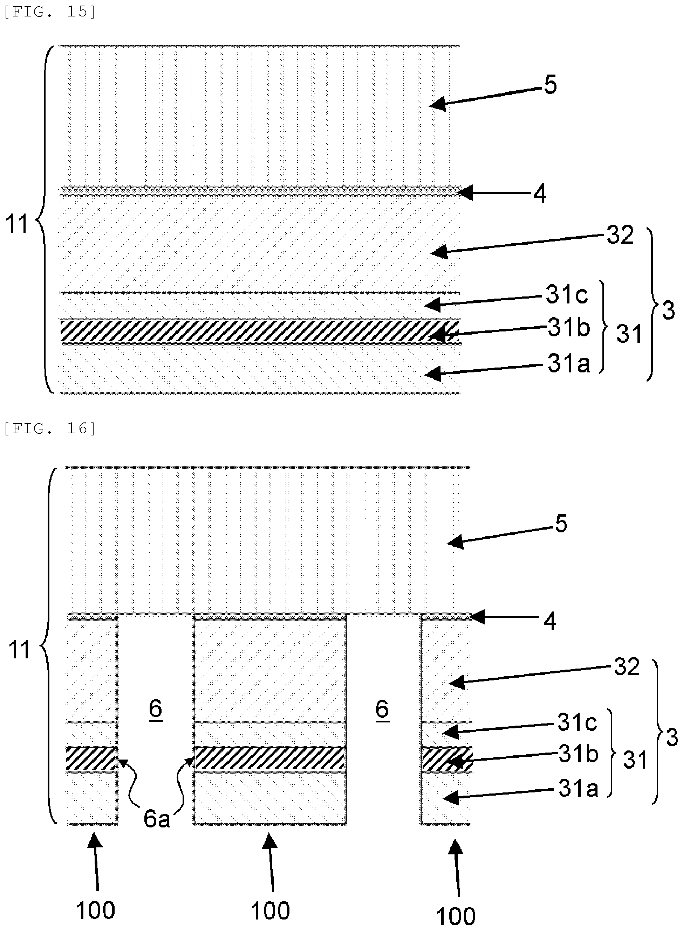

After the first etching stop layer of the etching stop layer 2 is exposed, the etchant is switched to a hydrochloric acid-based etchant to remove the first etching stop layer of GaInP selectively, and then the etchant is switched to a peroxide sulfuric-based etchant and the second etching stop layer is removed. Thereby, the etching stop layer 2 is removed, and the first cladding layer 31a is exposed, as shown in FIG. 15.

Then, a resist mask or a hard mask is formed on the compound semiconductor functional layer 3 by a photolithography method, and from the first cladding layer 31a to a GaP window layer 32 are etched by the dry etching method using chlorine-based plasma to form an isolation groove 6. Thus, devices (device separation edges) 100 in an island-shaped pattern separated from each other by the isolation groove 6 in the compound semiconductor functional layer 3, as shown in FIG. 16. When the devices 100 are devices for micro-LED, one side of each of the devices 100 is preferably 100 um or less. The preferred lower limit of length of one side of the device is not particularly limited but is, for example, 1 um or more.

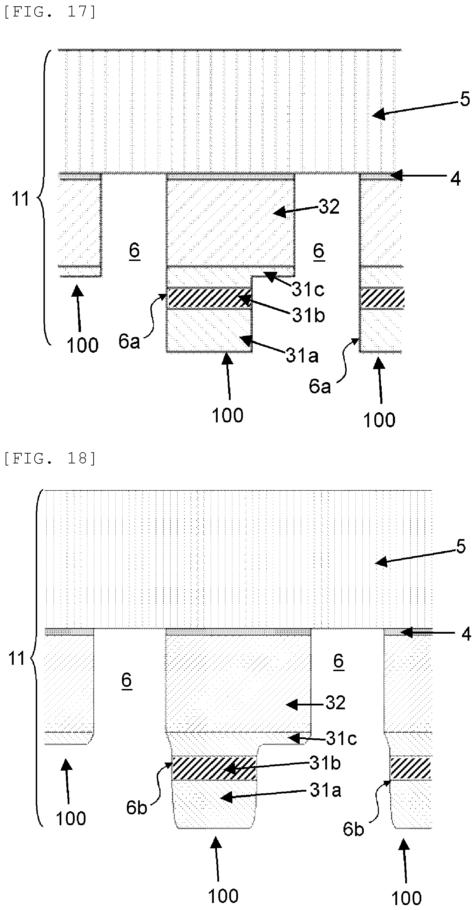

Then, a resist pattern or a hard mask pattern is formed by the photolithography method, and the device 100 is etched by, for example, the dry etching method using chlorine-based plasma to expose a part of the second cladding layer 31c, as shown in FIG. 17.

FIG. 17 shows a state in which the second cladding layer 31c is etched to the middle portion of the layer; however, an etched depth is not limited to this depth, and the same effect can be obtained at any depth as long as the etching passes through the active layer 31b. The same effects can be obtained, for example, in the state where a part of the active layer 31b is completely eliminated in the depth direction and the second cladding layer 31c is almost unetched, or in the state where a part of the second cladding layer 31c is completely etched in the depth direction and the GaP window layer 32 is exposed.

Subsequently, after the dry etching step to the device 100, the wet etching treatment is performed on a surface 6a of the isolation groove 6, shown in FIG. 17, by, for example, sulfuric acid-hydrogen peroxide mixture (SPM) solution (step to etching on the surface 6a of the isolation groove 6 by the wet etching method). Consequently, as shown in FIG. 18, the surface 6a of the isolation groove 6 (a part of a side surface of the compound semiconductor functional layer 3) becomes a wet etched surface 6b. By performing the wet etching in this way, a damaged layer formed by the dry etching at the isolation groove formation step and by the dry etching to the device 100 on the surface 6a of the isolation groove 6, i.e., the side surface of the compound semiconductor functional layer 3 can be removed, thereby suppressing brightness decrease of the devices 100 such as the micro-LED.

In the wet etching treatment, an etching removal is preferably 50 nm or more so as to sufficiently remove damage at the active layer 31b portion of the device (device separation edge) 100. By virtue of thus-performing wet etching of 50 nm or more, the damaged layer on the surface 6a of the isolation groove 6 can be more reliably removed, and thereby the brightness decrease of the devices 100, such as the micro-LED, can be further suppressed. The preferred upper limit of the etching removal by the wet etching treatment is not particularly limited, but the etching removal can be, for example, 1 um or less.

Regarding the etchant usable in the wet etching method, see the description in the first embodiment.

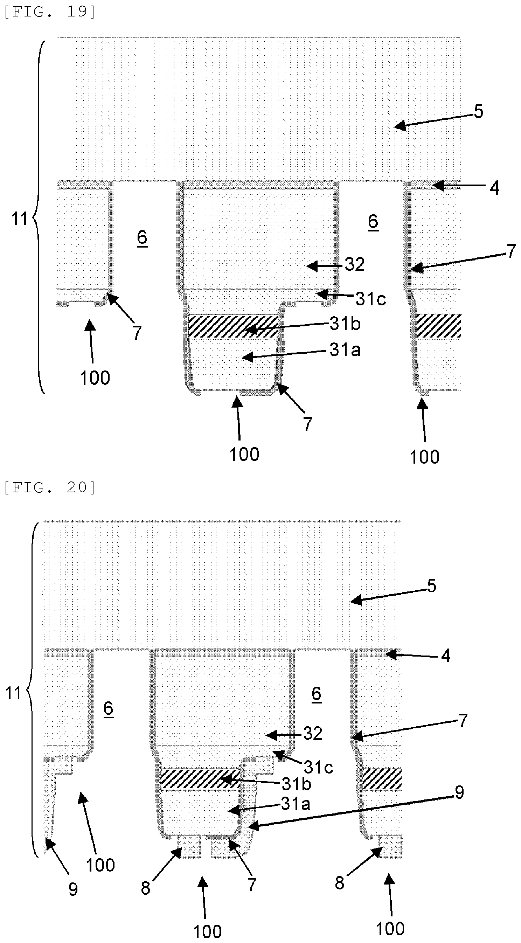

Then, a passivation (PSV) film 7, such as SiO₂, is formed on the surface of the device 100, and then the PSV pattern film 7 is produced, the pattern film being processed so that, as shown in FIG. 19, a side surface of the exposed active layer 31b in the device (device separation edge portion) 100 is coated and a part of the first cladding layer 31a and a part of the second cladding layer 31c are exposed.

It should be noted that, the PSV film 7 is not limited to SiO₂ film, but any material can be selected as long as a material has an insulating property. For the formation method of the PSV film, see the description in the first embodiment.

Then, as shown in FIG. 20, electrodes 8 and 9 are formed on a part of the first cladding layer 31a and a part of the second cladding layer 31c exposed from the opening of the PSV pattern film 7, respectively, and heat treatment is performed to realize an ohmic contact. For a material of the electrodes, see the description in the first embodiment.

Moreover, in FIG. 20, a design is exemplified in which a lead layer is provided with the electrode 9 in contact with the second cladding layer 31c and up to the height of the first cladding layer 31a; however, the design is not limited to the design having a lead structure. Without providing the lead structure, a structure may also be used in which the thickness of electrode 9 in contact with the second cladding layer 31c is designed to be thicker than that of electrode 8 on the first cladding layer 31a to reduce a difference in levels.

According to the second embodiment of the inventive method for manufacturing the bonded semiconductor wafer, described above, it is possible to manufacture a bonded semiconductor wafer 11 including a plurality of devices 100 bonded to the visible light-transmissive substrate 5 via a visible light-transmissive thermosetting bonding member coating film 4, as shown in FIG. 20. In FIG. 20, a plurality of the devices 100 are light emitting devices, and more specifically, micro-LED structures each having an active layer 31b, which is a light emitting layer, and a window layer 32.

In this embodiment, as described with referring to FIG. 18, after the isolation groove formation step by the dry etching method and the dry etching to the device 100, the wet etching is performed on the surface of the isolation groove 6, specifically, a surface of the compound semiconductor functional layer 3 by the wet etching method, thereby removing the damaged layer on the surface (side surface) of the compound semiconductor functional layer 3 formed by the dry etching.
Therefore, the brightness decrease of the devices 100, being the micro-LED, can be suppressed.

### (Third Embodiment)

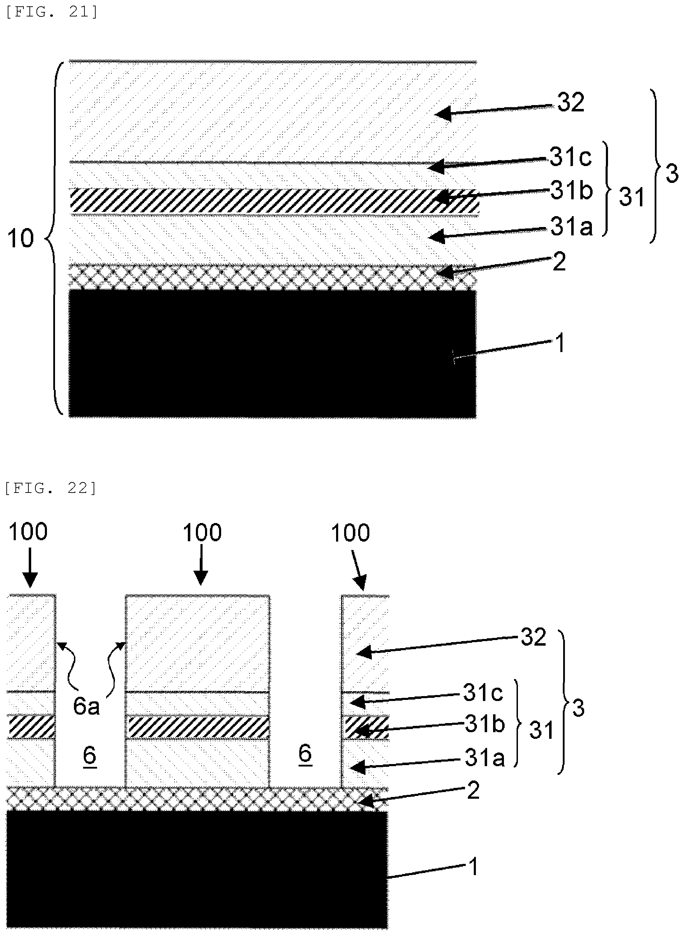

Next, referring to FIG. 21 to FIG. 32, the third embodiment of the inventive method for manufacturing the bonded semiconductor wafer is described.

The third embodiment generally differs from the first embodiment mainly in that after forming an isolation groove 6, wet etching is performed on a surface 6a of the isolation groove 6, followed by bonding a compound semiconductor functional layer 3 to a visible light-transmissive substrate 5.

To begin with, as shown in FIG. 21, according to the same procedure described in the first embodiment, an etching stop layer 2 is epitaxially grown on a first conductivity-type starting substrate 1 of GaAs, then a compound semiconductor functional layer 3 is epitaxially grown on the etching stop layer 2. Thus, an epitaxial wafer 10 having a light emitting device structure as the compound semiconductor functional layer (epitaxial functional layer) 3 epitaxially grown on the etching stop layer 2 is provided, as shown in FIG. 21.

Then, a resist mask or a hard mask is formed on the compound semiconductor functional layer 3 by a photolithography method, and from the first cladding layer 31a to a GaP window layer 32 are etched by the dry etching method using chlorine-based plasma to form an isolation groove 6. This forms devices (device separation edges) 100 in an island-shaped pattern separated from each other by the isolation groove 6 in the compound semiconductor functional layer 3, as shown in FIG. 22. When the devices 100 are devices for micro-LED, one side of each of the devices 100 is preferably 100 um or less. The preferred lower limit of length of one side of the device is not particularly limited but is, for example, 1 um or more.

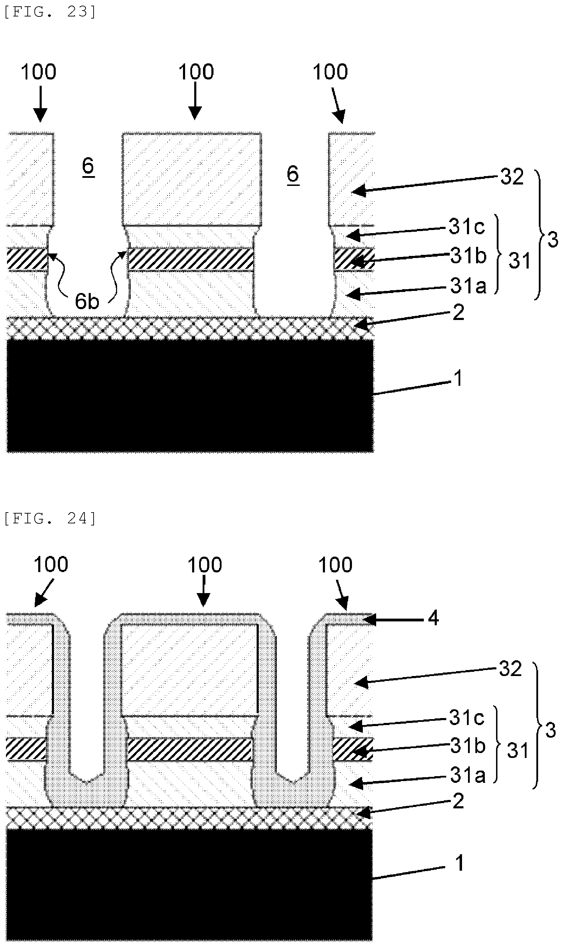

Subsequently, after performing the isolation groove formation step by the dry etching method, the wet etching treatment is performed on a surface 6a of the isolation groove 6 shown in FIG. 22 by, for example, sulfuric acid-hydrogen peroxide mixture (SPM) solution (step to etching by the wet etching method). Consequently, as shown in FIG. 23, the surface 6a of the isolation groove 6 (a side surface of the compound semiconductor functional layer 3) becomes a wet etched surface 6b. By virtue of thus-performing the wet etching, a damaged layer formed by the dry etching on the surface 6a of the isolation groove 6, i.e., on the side surface of the compound semiconductor functional layer 3 can be removed, thereby suppressing the brightness decrease of the devices 100 such as the micro-LED.

In the wet etching treatment, an etching removal is preferably 50 nm or more so as to sufficiently remove damage at the active layer 31b portion of the device (device separation edge) 100. By virtue of thus-performing wet etching of 50 nm or more, the damaged layer on the surface 6a of the isolation groove 6 can be more reliably removed, and thereby the brightness decrease of the devices 100, such as the micro-LED, can be further suppressed. The preferred upper limit of the etching removal by the wet etching treatment is not particularly limited, but the etching removal can be, for example, 1 um or less.

Then, as shown in FIG. 24, for example, benzocyclobutene (BCB) is spin-coated as a visible light-transmissive thermosetting bonding material on the epitaxial wafer 10 to obtain a visible light-transmissive thermosetting bonding member coating film (BCB coating film) 4. As shown in FIG. 24, a part of the BCB coating film 4 is also formed on the etching stop layer 2 of the bottom of the isolation groove 6.

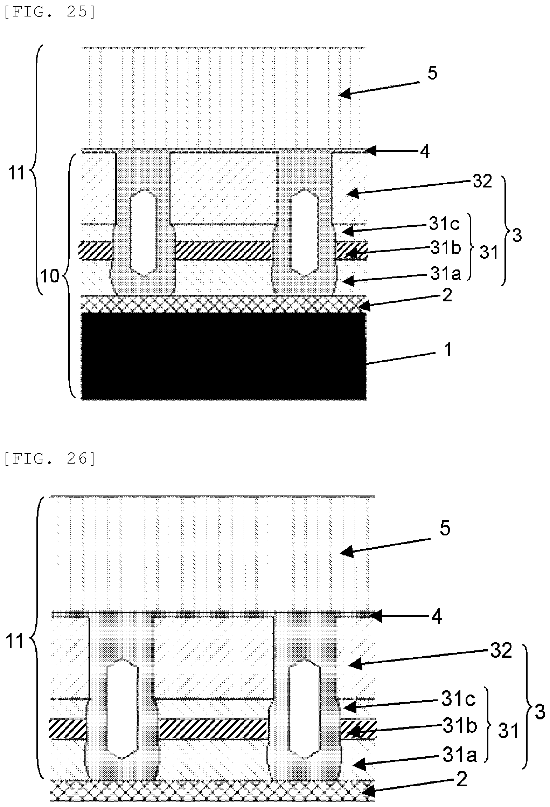

Next, as shown in FIG. 25, a visible light-transmissive substrate 5 as a to-be-bonded wafer, such as a sapphire wafer, is superimposed on the compound semiconductor functional layer 3 of the device 100 while facing this via the BCB coating film 4 sandwiched therebetween, and thermocompression-bonding is performed, thereby producing a bonded semiconductor wafer (epitaxial wafer bonded substrate) 11 in which the compound semiconductor functional layer 3 of the epitaxial 10 and a sapphire wafer 5 are bonded to each other via the BCB coating film 4. A thickness of the BCB coating film 4 can be about 0.01 µm or more and 0.6 um or less as in the first embodiment.

It should be noted that a BCB layer thickness of 0.05 um or more is suitable to maintain an area yield of 90 % or more after bonding. If the area yield of 70 % or more after bonding only needs to be maintained, the BCB layer thickness may be 0.01 um or more.

In this embodiment, the visible light-transmissive substrate 5 is exemplified as sapphire, and the visible light-transmissive thermosetting bonding member is exemplified as BCB; however, the examples are not limited to thereto. Other usable examples are the same as the examples mentioned in the first embodiment.

Then, as shown in FIG. 26, the GaAs starting substrate 1 is removed by the wet etching with a selective etchant such as ammonia hydrogen peroxide mixture. By this means, the GaAs starting substrate 1 is removed from the compound semiconductor functional layer 3 bonded to the visible light-transmissive substrate 5.

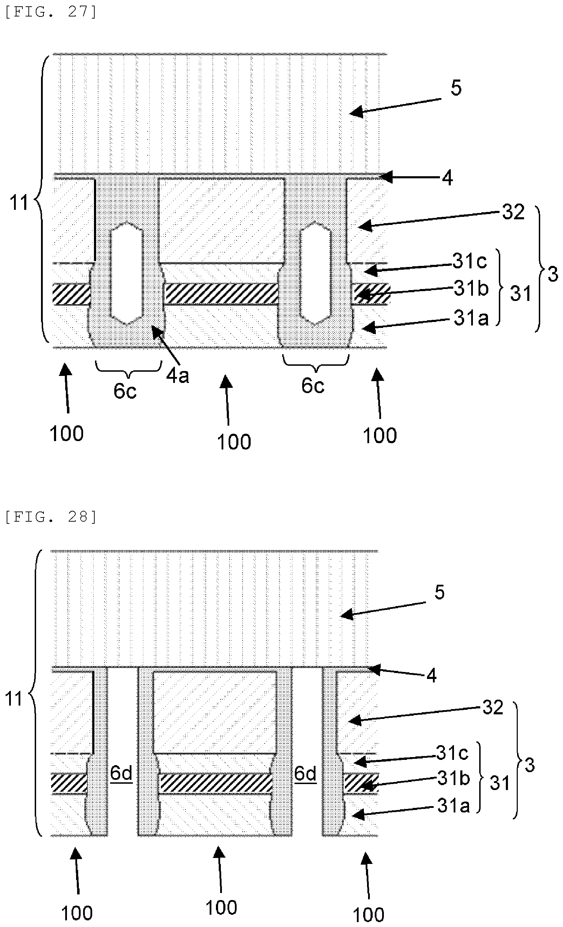

After the first etching stop layer of the etching stop layer 2 is exposed, the etchant is switched to a hydrochloric acid-based etchant and the first etching stop layer of GaInP is selectively removed, and then the etchant is switched to a peroxide sulfuric-based etchant and the second etching stop layer is removed. Thereby, the etching stop layer 2 is removed, and the first cladding layer 31a is exposed, as shown in FIG. 27.

Subsequently, by combining the photolithography method and etching, a part 4a of the BCB buried in the street portion (separation line used for separation into chips) 6c shown in FIG. 27 is removed to make a new isolation groove 6d as shown in FIG. 28.

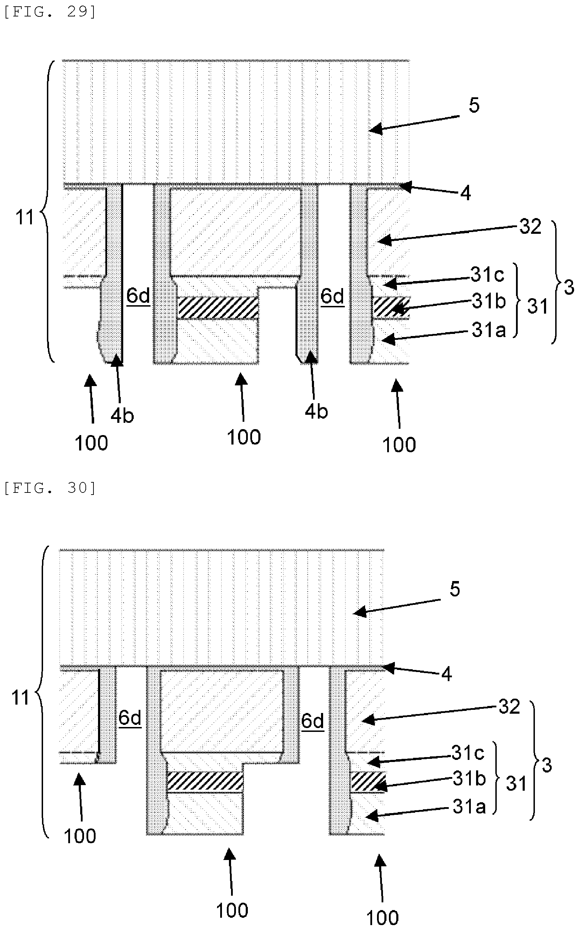

Then, a resist pattern or a hard mask pattern is formed on a surface of the device 100 by the photolithography method, and the device 100 is etched by the dry etching method using such as chlorine-based plasma to expose a part of a second cladding layer 31c as shown in FIG. 29.

FIG. 29 shows a state in which the second cladding layer 31c is etched to the middle portion of the layer; however, an etched depth is not limited to this depth, and the same effect can be obtained at any depth as long as the etching passes through the active layer 31b. The same effects can be obtained, for example, in the state where a part of the active layer 31b is completely eliminated in the depth direction and the second cladding layer 31c is almost unetched, or in the state where a part of the second cladding layer 31c is completely etched in the depth direction and the GaP window layer 32 is exposed.

Subsequently, after the dry etching step of the device 100, a part 4b of BCB, which remains in a protrusion state of a spike shape as shown in FIG. 29, is removed to make the state shown in FIG. 30. The etching treatment may be performed; however, due to weak mechanical strength of the part 4b of BCB, it can be removed simply and easily by performing high-pressure liquid current treatment. Alternatively, it can also be removed simply and easily by performing ashing treatment.

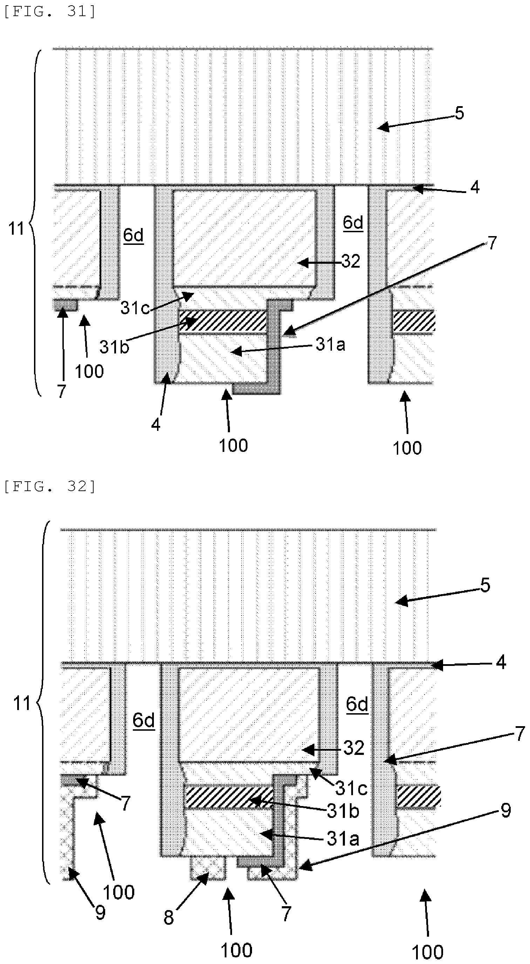

Then, a passivation (PSV) film 7, such as SiO₂, is formed on the surface of the device 100, and then the PSV pattern film 7 is produced, the pattern film being processed so that, as shown in FIG. 31, a side surface of the exposed active layer 31b in the device (device separation edge portion) 100 is coated and a part of the first cladding layer 31a and a part of the second cladding layer 31c are exposed.

It should be noted that, the PSV film 7 is not limited to SiO₂ film, but any material can be selected as long as a material has an insulating property. For the formation method of the PSV film, see the description in the first embodiment.

Then, as shown in FIG. 32, electrodes 8 and 9 are formed on a part of the first cladding layer 31a and a part of the second cladding layer 31c exposed from the opening of the PSV pattern film 7, respectively, and heat treatment is performed to realize an ohmic contact. For a material of the electrodes, see the description in the first embodiment.

Moreover, in FIG. 32, a design is exemplified in which a lead layer is provided with the electrode 9 in contact with the second cladding layer 31c and up to the height of the first cladding layer 31a; however, the design is not limited to the design having a lead structure. Without providing the lead structure, a structure may also be used in which the thickness of electrode 9 in contact with the second cladding layer 31c is designed to be thicker than that of electrode 8 on the first cladding layer 31a to reduce a difference in levels.

According to the third embodiment of the inventive method for manufacturing the bonded semiconductor wafer, described above, it is possible to manufacture a bonded semiconductor wafer 11 including a plurality of devices 100 bonded to the visible light-transmissive substrate 5 via a visible light-transmissive thermosetting bonding member coating film 4, as shown in FIG. 32. In FIG. 32, a plurality of the devices 100 are light emitting devices, and more specifically, micro-LED structures each having the active layer 31b, which is a light emitting layer, and the window layer 32.

In this embodiment, as described with referring to FIG. 23, after the isolation groove formation step by the dry etching method, the wet etching is performed on the surface 6a of the isolation groove 6, specifically, a surface of the compound semiconductor functional layer 3, by the wet etching method, thereby removing the damaged layer on the surface of the compound semiconductor functional layer 3 formed by the dry etching. Therefore, the brightness decrease of the device 100, being the micro-LED, can be suppressed.

In the first and second embodiments described earlier, the step of bonding the compound semiconductor functional layer 3 to the visible light-transmissive substrate 5, the step of obtaining the bonded semiconductor wafer 11 by removing the starting substrate 1 from the compound semiconductor functional layer 3, the step of forming the isolation groove 6 in the compound semiconductor functional layer 3, and the step of etching on the surface 6a of the isolation groove 6 by the wet etching method are performed in this first order. On the other hand, in the third embodiment, the step of forming the isolation groove 6 in the compound semiconductor functional layer 3, the step of etching on the surface 6a of the isolation groove 6 by the wet etching method, the step of bonding the compound semiconductor functional layer 3 to the visible light-transmissive substrate 5, and the step of obtaining the bonded semiconductor wafer by removing the starting substrate 1 from the compound semiconductor functional layer 3 are performed in this second order. That is, the inventive method for manufacturing the bonded semiconductor wafer may be performed in the first order described above or may be performed in the second order described above.

Should be noted that, in the inventive method for manufacturing the bonded semiconductor wafer, if the visible light-transmissive thermosetting bonding member is made not to be thermally cured, the visible light transmissive substrate can be easily delaminated when the delamination thereof is needed.

### EXAMPLES

Hereinafter, the present invention will be specifically described with reference to Examples and Comparative Example. However, the present invention is not limited thereto.

### (Example 1)

In Example 1, a bonded semiconductor wafer was manufactured according to the first embodiment of the inventive method for manufacturing the bonded semiconductor wafer described earlier, referring FIG. 1 to FIG. 10. Specifically, the procedures below were followed.

To begin with, as shown in FIG. 1, an etching stop layer 2 was epitaxially grown on a first conductivity-type GaAs starting substrate 1 after laminating a first conductivity-type GaAs buffer layer (not shown) thereon. The etching stop layer 2 included a first conductivity type GaₓIn₁₋ₓP (0.4 ≤ x ≤0.6) first etching stop layer having a thickness of 0.3 um and a first conductivity-type GaAs second etching stop layer having a thickness of 0.3 µm.

Then, as shown in FIG. 1, on the etching stop layer 2, a first conductivity-type first cladding layer 31a of (Al_{y}Ga_{1-y})ₓIn₁₋ₓP (0.4≤x≤0.6, 0<y≤1) (thickness of 1.0 µm), a non-doped (Al_{y}Ga_{1-y})ₓIn₁₋ₓP (0.4≤x≤0.6, 0≤y≤0.6) active layer 31b (thickness of 0.1 pm), a second conductivity type second cladding layer 31c of (Al_{y}Ga_{1-y})ₓIn₁₋ₓP (0.4 ≤ x ≤ 0.6, 0 < y ≤ 1) (thickness of 1.0 um), a second conductivity-type GaInP intermediate layer (not shown; thickness of 0.1 pm), a second conductivity-type GaP window layer 32 (thickness of 4 µm) were epitaxially grown in sequence. Consequently, an epitaxial wafer 10 having a light emitting device structure as a compound semiconductor functional layer (epitaxial functional layer) 3 epitaxially grown on the etching stop layer 2 was manufactured.

Then, as shown in FIG. 2, a BCB coating film 4 was obtained by spin-coating benzocyclobutene (BCB) as a thermosetting bonding material on the compound semiconductor functional layer 3 of the epitaxial wafer 10.

And then, as shown in FIG. 3, a sapphire wafer 5, as a to-be-bonded wafer, was superimposed on the compound semiconductor functional layer 3 with facing this via the BCB coating film 4 sandwiched therebetween and thermocompression-bonding was performed, thereby producing a bonded semiconductor wafer (epitaxial wafer bonded substrate) 11 in which the compound semiconductor functional layer 3 of the epitaxial wafer 10 and the sapphire wafer 5 were bonded to each other via the BCB coating film 4. When the BCB was coated by spin-coating, a designed film thickness was set as 0.6 µm.

Then, as shown in FIG. 4, the GaAs starting substrate 1 was removed by the wet etching treatment using ammonia hydrogen peroxide mixture solution, and then a first etching stop layer of GaInP was exposed. Subsequently, the etchant was switched to hydrochloric acid-based etchant, and the first etching stop layer of GaInP was selectively removed, and then the second etching stop layer of GaAs was exposed. Then, the etchant was switched to sulfuric acid-hydrogen peroxide mixture-based, and the second etching stop layer of GaAs was selectively removed, and then the first cladding layer 31a was exposed, as shown in FIG. 5.

Then, a resist mask was formed on the compound semiconductor functional layer 3 by a photolithography method, and from the first cladding layer 31a to a GaP window layer 32 was etched by the dry etching method using chlorine-based plasma to form an isolation groove 6 shown in FIG. 6. Thus, the devices 100 in an island-shaped pattern were formed in the compound semiconductor functional layer 3, as shown in FIG. 6.

After forming the devices 100 in the island-shaped pattern, the wet etching treatment was performed on a surface 6a of the isolation groove 6 shown in FIG. 6, using a sulfuric acid-hydrogen peroxide mixture-based solution. An etching removal was defined as 50 nm. By virtue of this treatment, as shown in FIG. 7, a part of a side surface of the compound semiconductor functional layer 3, being the surface 6a of the isolation groove 6, became a wet-etched surface 6b.

For the mixing ratio of the sulfuric acid-hydrogen peroxide mixture, the ratio of sulfuric acid : hydrogen peroxide : water was the ratio of 1 : 1 : 20.

Then, a resist pattern was formed on a surface of the device 100 by the photolithography method, and then the device 100 was etched by the dry etching method using chlorine-based plasma to expose a part of the second cladding layer 31c, as shown in FIG. 8.

Then, a SiO₂ film 7 was formed on the surface of the device 100, and then, a PSV pattern film (SiO₂ film) 7 was produced, the pattern film being processed so that, as shown in FIG. 9, a side surface of the exposed active layer 31b in the device 100 was coated, and a part of the first cladding layer 31a and a part of the second cladding layer 31c were exposed. The SiO₂ film 7 was formed by a P-CVD method using TEOS and O₂.

Then, as shown in FIG. 10, electrodes 8 and 9 were formed on the part of the first cladding layer 31a and the part of the second cladding layer 31c exposed from the openings of the SiO₂ film 7, respectively, and heat treatment was performed to realize an ohmic contact. Au-based materials were adopted for the electrodes 8 and 9.

With the above, a bonded semiconductor wafer 11 shown in FIG. 10, including a plurality of devices 100 bonded to the sapphire wafer 5 via the BCB coating film 4, was manufactured. A plurality of devices 100 were micro-LED structures each having an active layer 31b, which was a light emitting layer, and a window layer 32.

### (Example 2)

In Example 2, a bonded semiconductor wafer was manufactured according to the second embodiment of the inventive method for manufacturing the bonded semiconductor wafer described earlier, referring to FIG. 11 to FIG. 20. Specifically, the procedures below were followed.

To begin with, an epitaxial wafer 10 shown in FIG. 11 was manufactured in the same procedure as in Example 1.

Then, in the same procedure as in Example 1, benzocyclobutene (BCB) was spin-coated as a thermosetting bonding material on the compound semiconductor functional layer 3 of the epitaxial wafer 10 to obtain a BCB coating film 4 shown in FIG. 12, and then a bonded semiconductor wafer 11 was manufactured in which a compound semiconductor functional layer 3 of the epitaxial wafer 10 was bonded to a sapphire wafer 5 via the BCB coating film 4 as shown in FIG. 13. When BCB was coated by spin-coating, a designed film thickness was set as 0.6 µm.

Then, in the same procedure as in Example 1, the GaAs starting substrate 1 was removed, as shown in FIG. 14, then the etching stop layer 2 was removed to expose the first cladding layer 31a, as shown in FIG. 15.

Next, in the same procedure as in Example 1, an isolation groove 6 shown in FIG. 16 was formed by a dry etching method to form the devices 100 in the island-shaped pattern.

Then, a resist pattern was formed on the surface of the device 100 by a photolithography method, and the device 100 was etched by the dry etching method using chlorine-based plasma to expose a part of the second cladding layer 31c, as shown in FIG. 17.

After this, by sulfuric acid-hydrogen peroxide mixture-based solution, a wet etching treatment was performed on surface 6a of the isolation groove 6 shown in FIG. 17. An etching removal was set as 50 nm. Consequently, as shown in FIG. 18, a part of a side surface of the compound semiconductor functional layer 3, being the surface 6a of the isolation groove 6, became a wet-etched surface 6b.

For the mixing ratio of the sulfuric acid-hydrogen peroxide mixture, the ratio of sulfuric acid : hydrogen peroxide : water was the ratio of 1 : 1 : 20.

Then, a SiO₂ film 7 was formed on the surface of the device 100, and then, a PSV pattern film (SiO₂ film) 7 was produced, the pattern film being processed so that, as shown in FIG. 19, a side surface of the exposed active layer 31b in the device 100 was coated, and a part of the first cladding layer 31a and a part of the second cladding layer 31c were exposed. The SiO₂ film 7 was formed by a P-CVD method using TEOS and O₂.

Then, as shown in FIG. 20, electrodes 8 and 9 were formed on a part of the first cladding layer 31a and a part of the second cladding layer 31c exposed from the openings of the SiO₂ film 7, respectively, and heat treatment was performed to realize an ohmic contact. Au-based materials were adopted for the electrodes 8 and 9.

With the above, as shown in FIG. 20, the bonded semiconductor wafer 11, including a plurality of devices 100 bonded to the sapphire wafer 5 via the BCB coating film 4, was manufactured. A plurality of devices 100 were micro-LED structures each having an active layer 31b, which was a light emitting layer, and a window layer 32.

### (Example 3)

In Example 3, a bonded semiconductor wafer was manufactured according to the third embodiment of the inventive method for manufacturing the bonded semiconductor wafer described earlier, referring FIG. 21 to FIG. 32. Specifically, the procedures below were followed.

To begin with, an epitaxial wafer 10 shown in FIG. 21 was manufactured in the same procedure as in Example 1.

Next, a resist mask was formed on the compound semiconductor functional layer 3 by a photolithography method, and from the first cladding layer 31a to the GaP window layer 32 was etched by a dry etching method using chlorine-based plasma to form an isolation groove 6 shown in FIG. 22 was formed. This formed devices 100 in an island-shaped pattern in the compound semiconductor functional layer 3, as shown in FIG. 22.

After forming the devices 100 in the island-shaped pattern, the wet etching treatment was performed on a surface 6a of the isolation groove 6 shown in FIG. 22 using a sulfuric acid-hydrogen peroxide mixture-based solution. An etching removal was set as 50 nm. Thus, as shown in FIG. 23, a part of a side surface of the compound semiconductor functional layer 3, being the surface 6a of the isolation groove 6, became a wet-etched surface 6b.

For the mixing ratio of the sulfuric acid-hydrogen peroxide mixture, the ratio of sulfuric acid : hydrogen peroxide : water was the ratio of 1 : 1 : 20.

Then, as shown in FIG. 24, benzocyclobutene (BCB) was spin-coated as a visible light-transmissive thermosetting bonding material on the epitaxial wafer 10 to obtain a BCB coating film 4. When the BCB was coated by spin-coating, a designed film thickness was set as 0.6 µm.

Next, as shown in FIG. 25, a sapphire wafer, as a to-be-bonded wafer, was superimposed on the compound semiconductor functional layer 3 of the device 100 with facing this via the BCB coating film 4 sandwiched therebetween and thermocompression-bonding was performed, thereby producing a bonded semiconductor wafer 11 in which the compound semiconductor functional layer 3 of the epitaxial wafer 10 and the sapphire wafer 5 were bonded to each other via the BCB coating film 4.

Then, as shown in FIG. 26, the GaAs starting substrate 1 was removed by the wet etching treatment using ammonia hydrogen peroxide mixture solution to expose the GaInP first etching stop layer. Subsequently, the etchant was switched to hydrochloric acid-based etchant, and the GaInP first etching stop layer was selectively removed to expose the GaAs second etching stop layer. Then, the etchant was switched to sulfuric acid-hydrogen peroxide mixture-based, and the GaAs second etching stop layer was selectively removed to expose the first cladding layer 31a, as shown in FIG. 27.

Subsequently, the resist mask was formed by the photolithography method, and a part 4a of the BCB buried in the street portion (separation line used for separation into chips) 6c was removed by the dry etching method using fluorine-based plasma to make a new isolation groove 6d as shown in FIG. 28. It should be noted that an ICP method was employed as the dry etching method.

Then, a resist pattern or a hard mask pattern was formed on the surface of the device 100 by the photolithography method, and the device 100 was etched by the dry etching method using chlorine-based plasma to expose a part of a second cladding layer 31c, as shown in FIG. 29.

After the dry etching step of the device 100, a part 4b of BCB, which remained in a protrusion state of a spike shape as shown in FIG. 29, was removed to make the state shown in FIG. 30.

Then, a SiO₂ film 7 was formed on the surface of the device 100, and then a PSV pattern film (SiO₂ film) 7 was produced, the pattern film being processed so that, as shown in FIG. 31, a side surface of the exposed active layer 31b in the device (device separation edge) 100 was coated, and a part of the first cladding layer 31a and a part of the second cladding layer 31c were exposed. The SiO₂ film 7 was formed by a P-CVD method using TEOS and O₂.

Then, as shown in FIG. 32, electrodes 8 and 9 were formed on a part of the first cladding layer 31a and a part of the second cladding layer 31c exposed from the openings of the SiO₂ film 7, respectively, and heat treatment was performed to realize an ohmic contact. Au-based materials were adopted for the electrodes 8 and 9.

With the above, as shown in FIG. 32, the bonded semiconductor wafer 11, including a plurality of devices 100 bonded to the sapphire wafer 5 via the BCB coating film 4, was manufactured. A plurality of devices 100 were micro-LED structures each having an active layer 31b, which was a light emitting layer, and a window layer 32.

### (Comparative Example)

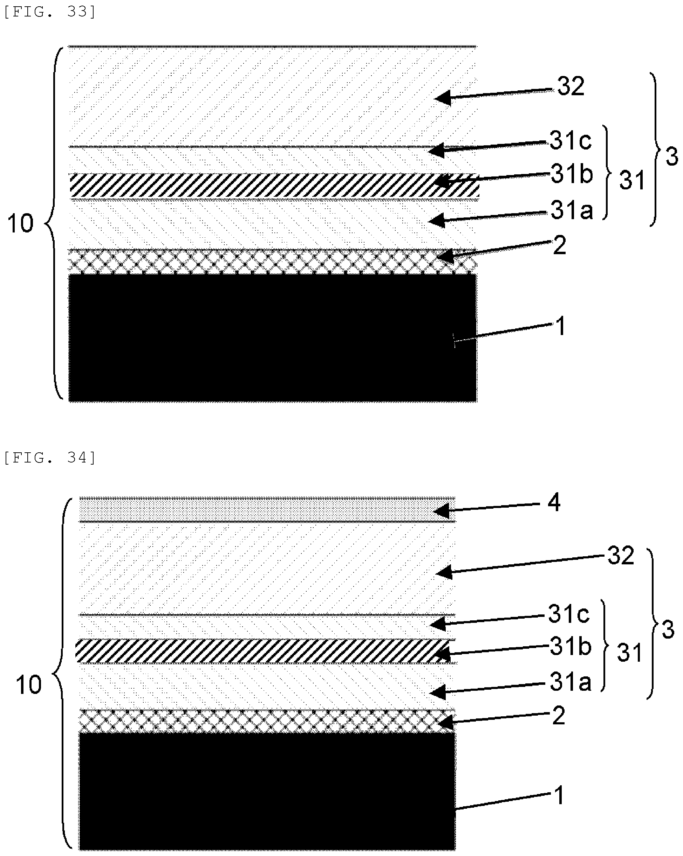

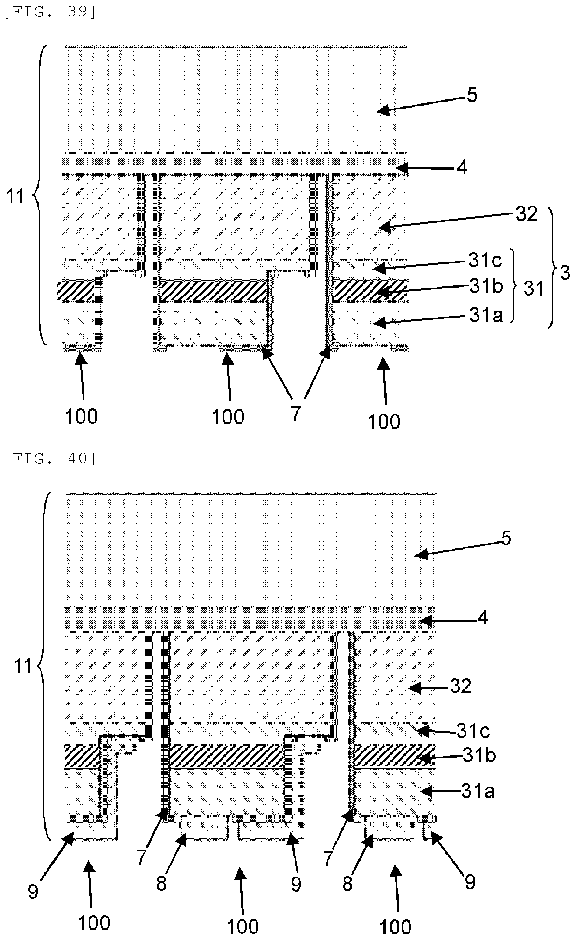

In Comparative Example, a bonded semiconductor wafer 11 shown in FIG. 40 was manufactured according to a procedure described below, referring to FIGS. 33 to 40.

To begin with, an epitaxial wafer 10 shown in FIG. 33 was manufactured in the same procedure as in Example 1.

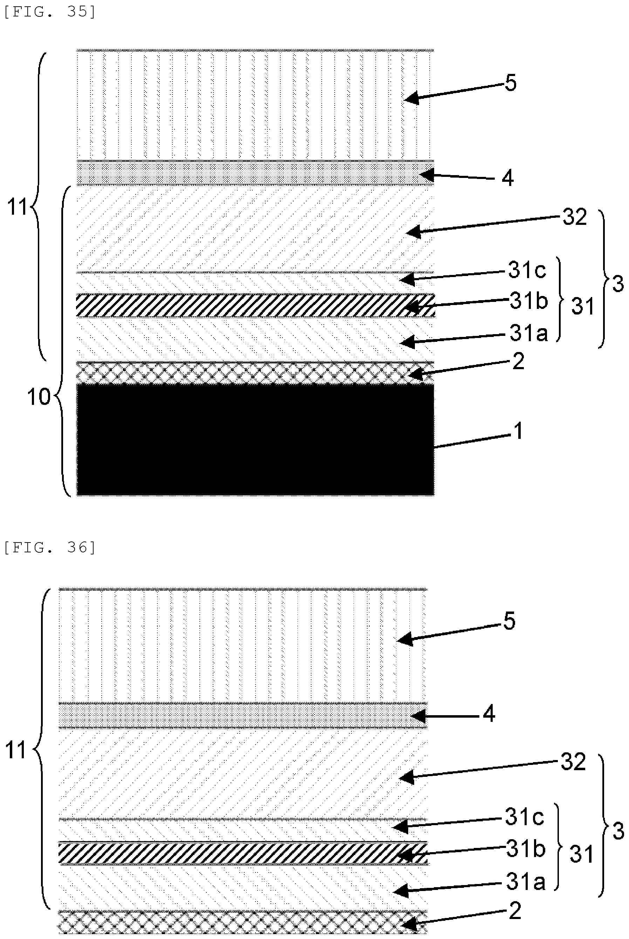

Then, in the same procedure as in Example 1, benzocyclobutene (BCB) was spin-coated as a thermosetting bonding material on the compound semiconductor functional layer 3 of the epitaxial wafer 10 to obtain a BCB coating film 4 shown in FIG. 34, and then a bonded semiconductor wafer 11 was manufactured in which a compound semiconductor functional layer 3 of the epitaxial wafer 10 was bonded to a sapphire wafer 5 via the BCB coating film 4, as shown in FIG. 35. When BCB was coated by spin-coating, a designed film thickness was set as 0.6 µm.

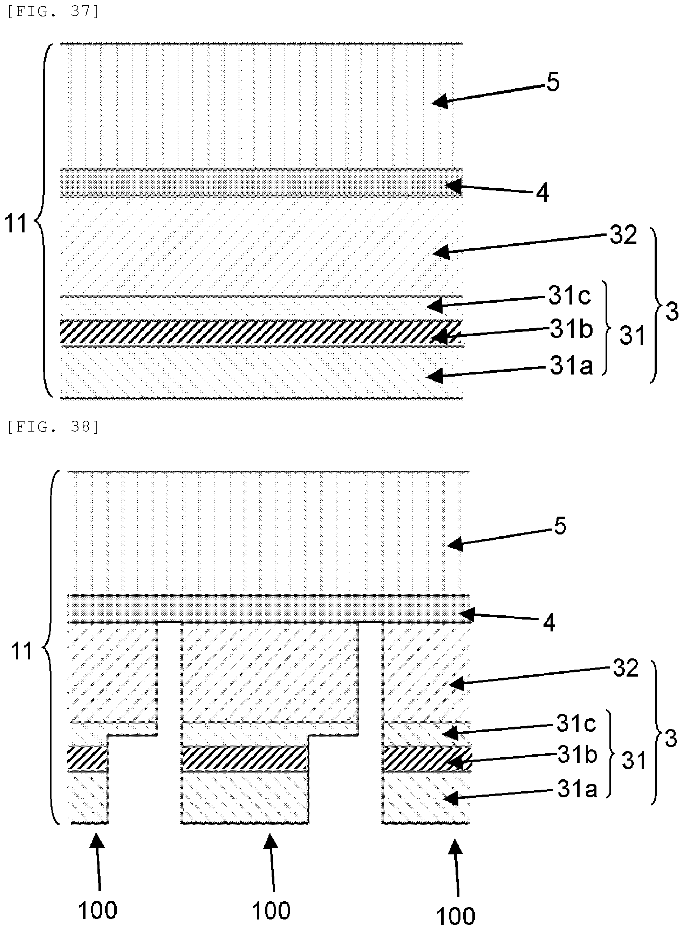

And then, in the same procedure as in Example 1, the GaAs starting substrate 1 was removed, as shown in FIG. 36, then an etching stop layer 2 was removed to expose a first cladding layer 31a, as shown in FIG. 37.

Next, a resist mask was formed on the compound semiconductor functional layer 3 by a photolithography method, and from the first cladding layer 31a to a GaP window layer 32 was etched by the dry etching method using chlorine-based plasma to form devices in an island-shaped pattern. Furthermore, a resist pattern was formed on the surface of the devices 100 of the island-shaped pattern by the photolithography method, and the device was etched by the dry etching method using chlorine-based plasma to form the devices 100 in which a part of the second cladding layer 31c was exposed as shown in FIG. 38.

Then, a SiO₂ film 7 was formed on the surface of the device 100, a PSV pattern film (SiO₂ film) 7 was produced, the pattern film being processed so that, as shown in FIG. 39, a side surface of the exposed active layer in the device 100 was coated, and a part of the first cladding layer 31a and a part of the second cladding layer 31c were exposed. The SiO₂ film 7 was formed by a P-CVD method using TEOS and O₂.

Then, as shown in FIG. 40, electrodes 8 and 9 were formed on a part of the first cladding layer 31a and a part of the second cladding layer 31c exposed from the openings of the SiO₂ film 7, respectively, and heat treatment was performed to realize an ohmic contact. Au-based materials were adopted for the electrodes 8 and 9.

With the above, the bonded semiconductor wafer 11, as shown in FIG. 40, including a plurality of devices 100 bonded to the sapphire wafer 5 via the BCB coating film 4, were manufactured. A plurality of devices 100 were micro-LED structures each having an active layer 31b, which was a light emitting layer, and a window layer 32.

As described above, Comparative Example significantly differed from Examples 1 to 3 in that wet etching was not performed after an isolation groove 6 formation step by the dry etching method.

### [Evaluation]

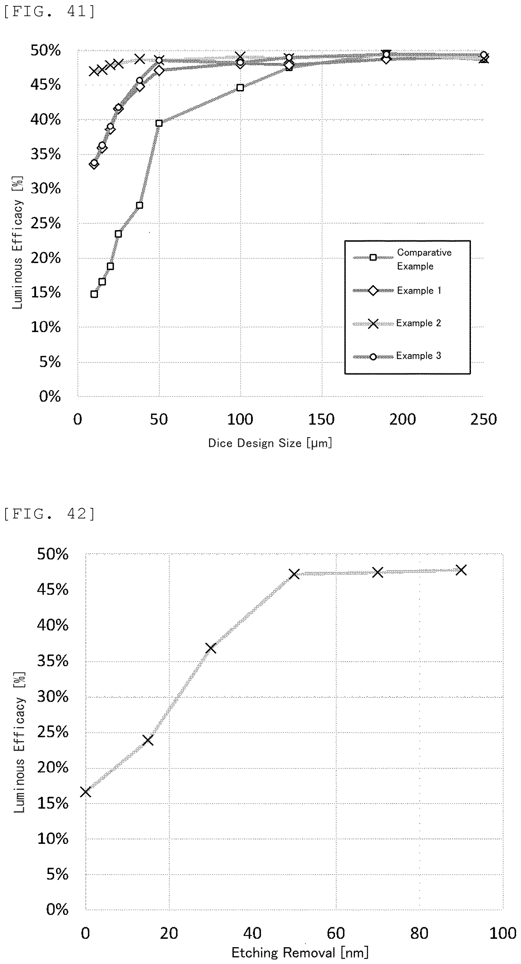

Furthermore, FIG. 41 shows a relation between a micro-LED size and external quantum efficiency (luminous efficacy) at a current density of 8 [A/cm²] for Examples 1 to 3 and Comparative Example when the size of one side of micro-LED 100 was varied from 15 to 250 µm.

From FIG. 41, it is found that in Comparative Example, the luminous efficacy steeply decreases as the micro-LED size becomes smaller in Comparative Example; however, in Examples 1 to 3, the degree of the decrease in luminous efficacy is moderate or the luminous efficacy does not fluctuate. That is, according to the present invention, when a device such as the micro-LED is produced on a substrate, there can be made devices having suppressed generation of brightness.

Although in Examples 1 and 3, the wet etching treatment was performed on the surface 6a of the isolation groove 6 after the formation of the isolation groove 6 by the dry etching, the wet etching treatment was not performed after the dry etching being performed to expose a part of the second cladding layer 31c as shown in FIG. 8 or FIG. 29. Therefore, it is found that in Examples 1 and 3, the wet etching treatment was performed on not all the side surfaces of the active layer 31b; thus, the luminous efficacy tends to slightly decrease accompanied by the miniaturization of the micro-LED; but the extent of the decrease is mitigated compared to Comparative Example.

On the other hand, it is found that, in Example 2, in which the wet etching treatment was performed after the dry etching of the device 100 and then the wet etching treatment was performed on all the side surfaces of the active layer 31b, the decrease in luminous efficacy accompanied by the miniaturization of the micro-LED was very slight.

In addition, Table 1 shows a comparison of surface roughness (unit: nm) between the window layer 32 and the active layer 31b of dice having one side size of 100 µm with regard to Example 2 (with wet etching) and Comparative Example (without wet etching).

**[Table 1]**

| | Window Layer | Active Layer |
|---|---|---|
| Without Wet Etching (Comparative Example) | 1.48 | 1.34 |
| With Wet Etching (Example 2) | 1.52 | 0.76 |

The roughness (surface roughness) on the GaP window layer 32 portion of Example 2, in which the wet etching was performed, does not have a remarkable difference from that of Comparative Example without performing the wet etching treatment; but the roughness of the active layer 31b varies significantly depending on presence or absence of the wet etching treatment. This indicates that the surface of the side surface of the active layer 31b was etched by the wet etching.

Moreover, FIG. 42 shows the luminous efficacy change according to variation of an etching removal (design etching width) in the wet etching under the above conditions of Example 2, in the case where one side of each of the devices 100 to be produced is 15 µm.

From FIG. 42, it is found that the degree of decrease in luminous efficacy improves with an increase in the etching removal. On the other hand, it is found that in the etching removal of 50 nm or more, the improvement effect is become smaller. Therefore, it is found that the effect of the wet etching can be notably realized by wet etching at the etching removal of 50 nm or more. However, as clear from FIG. 42, as long as the wet etching is performed at the etching removal of 0 nm or more, the decrease of luminous efficacy can be suppressed compared to the case without the wet etching (etching removal : 0 nm).

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing a bonded semiconductor wafer, the method comprising the steps of:
epitaxially growing an etching stop layer on a starting substrate;
epitaxially growing a compound semiconductor functional layer on the etching stop layer;
forming an isolation groove for forming a device in the compound semiconductor functional layer by a dry etching method;
etching on a surface of the isolation groove by a wet etching method;
bonding a visible light-transmissive substrate of a different material from a material of the compound semiconductor functional layer to the compound semiconductor functional layer via a visible light-transmissive thermosetting bonding member; and
obtaining a bonded semiconductor wafer by removing the starting substrate from the compound semiconductor functional layer bonded to the visible light-transmissive substrate.

2. The method for manufacturing a bonded semiconductor wafer according to claim 1,
wherein the step of bonding, the step of obtaining the bonded semiconductor wafer by removing the starting substrate, the step of forming the isolation groove, and the step of etching by the wet etching method are performed in this first order, or
the step of forming the isolation groove, the step of etching by the wet etching method, the step of bonding, and the step of obtaining the bonded semiconductor wafer by removing the starting substrate are performed in this second order.

3. The method for manufacturing a bonded semiconductor wafer according to claim 1 or 2,
wherein in the step of forming the isolation groove, the isolation groove is formed in the compound semiconductor functional layer, and thus, one side of the device is 100 um or less.

4. The method for manufacturing a bonded semiconductor wafer according to any one of claims 1 to 3,
wherein the device is a micro-LED structure having a light emitting layer and a window layer.

5. The method for manufacturing a bonded semiconductor wafer according to any one of claims 1 to 4,
wherein an etching removal of the wet etching is 50 nm or more.

6. The method for manufacturing a bonded semiconductor wafer according to any one of claims 1 to 5,
wherein the visible light-transmissive substrate is selected from the group consisting of sapphire, quartz, glass, SiC, LiTaO₃, and LiNbO₃.

7. The method for manufacturing a bonded semiconductor wafer according to any one of claims 1 to 6,
wherein the visible light-transmissive thermosetting bonding member is selected from the group consisting of BCB, silicone resin, epoxy resin, SOG, polyimide, and amorphous fluoropolymer.

8. The method for manufacturing a bonded semiconductor wafer according to any one of claims 1 to 7,
wherein a thickness of the visible light-transmissive thermosetting bonding member is 0.01 um or more and 0.6 um or less.

9. The method for manufacturing a bonded semiconductor wafer according to any one of claims 1 to 8,
wherein the visible light-transmissive thermosetting bonding member is not thermally cured.
